# EUROPEAN PATENT APPLICATION

(11) **EP 4 694 607 A1**
(43) Date of publication of application: **11.02.2026**
(21) Application number: 24853334.1
(22) Date of filing: 06.06.2024
(51) Int. Cl.: H05K 9/00

(54) **STRUCTURAL MEMBER AND ELECTRONIC DEVICE**

(30) Priority: 14.08.2023 CN 202311024753
(71) Applicant: Huawei Technologies Co., Ltd., Shenzhen, Guangdong 518129 (CN)
(72) Inventor: LI, Heng, Shenzhen, Guangdong 518129 (CN); XIONG, Zhenmin, Shenzhen, Guangdong 518129 (CN)
(74) Representative: MERH-IP Matias Erny Reichl Hoffmann Patentanwälte PartG mbB
(86) International application number: PCT/CN2024/097857
(87) International publication number: WO 2025/035919

(57) **Abstract**

Embodiments of this application disclose a mechanical part and an electronic device, and relate to the field of electronic device technologies, to resolve a technical problem that a carbon fiber composite material is prone to ESD. The mechanical part includes a mechanical part body and a conductive part. The mechanical part body includes an insulation part and a carbon fiber filament. The carbon fiber filament is embedded in the insulation part, and a part of the carbon fiber filament is exposed outside the insulation part. The conductive part is at least partially in contact with and electrically connected to the exposed carbon fiber filament. Because the carbon fiber filament has good conductivity, the conductive part disposed on the mechanical part body and the exposed carbon fiber filament can be conducted, to form a conductive path, so that the carbon fiber filament in the mechanical part may be used as a discharge path of an electrostatic current. In addition, the conductive part in the mechanical part may also be used as a point for electrical connection. When a large current passes through the mechanical part, the electrostatic current may be discharged through the carbon fiber filament and the conductive part, to reduce an ESD problem.

## Description

This application claims priority to Chinese Patent Application No. 202311024753.1, filed with the China National Intellectual Property Administration on August 14, 2023 and entitled "MECHANICAL PART AND ELECTRONIC DEVICE", which is incorporated herein by reference in its entirety.

### TECHNICAL FIELD

This application relates to the field of electronic device technologies, and in particular, to a mechanical part and an electronic device.

### BACKGROUND

Currently, a composite material like aluminum alloy, magnesium alloy, stainless steel, or titanium alloy is mostly used as a middle frame or a housing of an electronic device like a mobile phone, a tablet computer, or a notebook computer. Consequently, a weight of the electronic device cannot be reduced to implement a lightweight design. Although a carbon fiber composite material has characteristics such as high strength, a light weight, and good flexibility, the carbon fiber composite material has poor electrical conductivity. When subjected to a large current, the carbon fiber composite material is prone to electrostatic discharge (electrostatic discharge, ESD), which causes an electronic component in the electronic device to burn out.

### SUMMARY

Embodiments of this application provide a mechanical part and an electronic device, to resolve a technical problem that a carbon fiber composite material is prone to ESD.

To achieve the foregoing objective, this application uses the following technical solutions.

According to a first aspect of embodiments of this application, a mechanical part is provided. The mechanical part includes a mechanical part body and a conductive part. The mechanical part body includes an insulation part and a carbon fiber filament. The carbon fiber filament is embedded in the insulation part, and a part of the carbon fiber filament is exposed outside the insulation part. The conductive part is at least partially in contact with and electrically connected to the exposed carbon fiber filament.

It can be learned from the foregoing that, in this embodiment of this application, the part of the carbon fiber filament embedded in the insulation part is exposed outside the insulation part. In addition, the conductive part is disposed on the mechanical part body, so that the conductive part is at least partially in contact with the carbon fiber filament. In this way, because the carbon fiber filament has good conductivity, the conductive part disposed on the mechanical part body and the exposed carbon fiber filament can be conducted, to form a conductive path, so that the carbon fiber filament in the mechanical part may be used as a discharge path of an electrostatic current. In addition, the conductive part in the mechanical part may also be used as a point for electrical connection. When a large current passes through the mechanical part, the electrostatic current may be discharged through the carbon fiber filament and the conductive part, to reduce an ESD problem.

In some implementations, a groove is disposed in a surface of the mechanical part body, and the part of the carbon fiber filament is exposed in the groove. The conductive part is at least partially disposed in the groove of the mechanical part body, and the conductive part is in contact with and electrically connected to the carbon fiber filament exposed in the groove. Therefore, the groove is disposed in the surface of the mechanical part body, so that the part of the carbon fiber filament embedded in the insulation part can be exposed in the groove. In this case, the conductive part may be at least partially disposed in the groove, and is in contact with the exposed carbon fiber filament, so that good contact between the conductive part and the exposed carbon fiber filament is ensured under molding effect of the groove on the conductive part.

In some implementations, a plurality of carbon fiber filaments are disposed. The groove includes a groove wall, a groove bottom, and groove space enclosed by the groove wall and the groove bottom. The exposed carbon fiber filament is disposed on at least one of the groove wall, the groove bottom, and the groove space. Therefore, the carbon fiber filament in the groove may be exposed in at least one of the groove wall, the groove bottom, and the groove space, so that the conductive part may be in contact with the exposed carbon fiber filament at a plurality of positions of the mechanical part body, to improve reliability of contact between the conductive part and the carbon fiber filament.

In some implementations, a plurality of grooves are disposed in the surface of the mechanical part body, and the mechanical part body includes a first wall surface and a second wall surface that are connected. One part of the groove is disposed on the first wall surface, and the other part of the groove is disposed on the second wall surface. Therefore, the part of the groove may be disposed on the first wall surface of the mechanical part body, so that the conductive part may be disposed on the first wall surface of the mechanical part body. The other part of the groove may alternatively be disposed on the second wall surface of the mechanical part body, so that the conductive part may also be disposed on the second wall surface of the mechanical part body. In this way, electrical connection points of the mechanical part can be increased, to facilitate an electrical connection between the mechanical part and the electronic component.

In some implementations, an outer surface of the exposed carbon fiber filament protrudes from the groove bottom, and the conductive part is in contact with and electrically connected to an outer surface of the carbon fiber filament protruding from the groove bottom. Therefore, the outer surface of the carbon fiber filament exposed in the groove may be in a structure form protruding from the groove bottom, so that the mechanical part may be slotted through ion beam etching or photolithography.

In some implementations, the exposed carbon fiber filament has a first section plane, the first section plane is flush with the groove wall, and the conductive part is in contact with and electrically connected to the first section plane of the carbon fiber filament. Therefore, the first section plane of the carbon fiber filament exposed in the groove may be flush with the groove wall, so that the mechanical part may be slotted through polishing, grinding, or wire drawing.

In some implementations, the exposed carbon fiber filament has a second section plane, the second section plane is flush with the groove bottom, and the conductive part is in contact with and electrically connected to the second section plane of the carbon fiber filament. Therefore, the second section plane of the carbon fiber filament exposed in the groove may be flush with the groove bottom, so that the mechanical part may be slotted through polishing, grinding, or wire drawing.

In some implementations, the groove further includes a partition wall, and the partition wall is connected to the groove bottom and is spaced from the groove wall. The exposed carbon fiber filament has a third section plane, the third section plane is flush with a side wall of the partition wall, and the conductive part is in contact with and electrically connected to the third section plane of the carbon fiber filament. Therefore, the third section plane of the carbon fiber filament exposed in the groove may be flush with the side wall of the partition wall, so that the mechanical part may be slotted through ion beam etching, photolithography, polishing, grinding, or wire drawing.

In some implementations, the conductive part includes a conductive layer and a base layer. The base layer is disposed in the groove of the mechanical part body, and the base layer is in contact with and electrically connected to the exposed carbon fiber filament. The conductive layer is filled in the groove of the mechanical part body, and the conductive layer is in contact with and electrically connected to the base layer. Therefore, the exposed carbon fiber filament may be in contact with and electrically connected to the base layer, and the conductive layer may be in contact with and electrically connected to the base layer, to form a three-layer force-bearing structure including the carbon fiber filament, the base layer, and the conductive layer. Therefore, reliability of a connection between the conductive part and the carbon fiber filament is improved, and detachment between the conductive part and the carbon fiber filament is avoided.

In some implementations, the exposed carbon fiber filament is provided with an uneven surface, and the groove includes a groove wall and a groove bottom. The base layer is plated on the groove wall and the groove bottom, and is in contact with the uneven surface of the exposed carbon fiber filament. Therefore, roughening may be performed on the surface of the carbon fiber filament, so that the surface of the carbon fiber filament is uneven, and a specific surface area of the carbon fiber filament may be increased, thereby improving bonding strength between the base layer and the carbon fiber filament.

In some implementations, alloy is formed through fusion at an interface between the conductive layer and the base layer. Therefore, bonding strength between the conductive layer and the base layer can be improved, so that the conductive layer and the base layer are not easily detached.

In some implementations, a material of the conductive layer includes tin, bismuth, gallium, or indium. Therefore, low-melting-point metal like tin, bismuth, gallium, or indium can bond with a carbon fiber filament in a liquid state, and can fill the groove. After being hardened and molded, the conductive layer can be used as a point for electrical connection, so that the mechanical part can be electrically connected to an external electronic component.

In some implementations, a material of the base layer includes chromium, nickel, titanium, copper, iron, or aluminum. Therefore, chromium, nickel, titanium, copper, iron, or aluminum may be fused with the foregoing tin, bismuth, gallium, or indium to form alloy, so as to improve bonding strength between the conductive layer and the base layer.

In some implementations, the mechanical part further includes a connecting piece, and the connecting piece is disposed on the conductive part and is electrically connected to the conductive part. Therefore, the connecting piece is disposed to facilitate an electrical connection between the mechanical part and the external electronic component.

In some implementations, the connecting piece includes a pad, a conductive elastomer, or conductive silicone. Therefore, different connecting piece structures may be selected based on different electronic device structures.

In some implementations, the mechanical part further includes a metal plating layer, the metal plating layer is plated on the outer surface of the mechanical part body, and the conductive part is electrically connected to the metal plating layer. Therefore, the conductive part is electrically connected to the metal plating layer, so that the metal plating layer of the mechanical part can be used as a reference ground of the electronic component, and the electronic component can be grounded through the metal plating layer.

In some implementations, the mechanical part further includes graphene, the graphene is embedded in the insulation part, and the graphene is in contact with the carbon fiber filament. Therefore, the graphene has good thermal conductivity, so that the mechanical part can be used as a good thermally conductive medium.

In some implementations, the mechanical part is a middle frame or a rear cover of an electronic device. Therefore, the mechanical part may be used as the middle frame or the rear cover of the electronic device, so that the mechanical part is electrically connected to an electronic component in the electronic device, to reduce an ESD problem.

According to a second aspect of embodiments of this application, an electronic device is provided. The electronic device includes a circuit board, a connecting piece, and the mechanical part in the foregoing embodiments. The connecting piece is electrically connected between the circuit board and the mechanical part. The mechanical part of the electronic device has same technical effect as the mechanical part in the first aspect. Details are not described herein again.

In some implementations, the connecting piece is disposed on the circuit board, and is electrically connected to the circuit board. The connecting piece on the circuit board is electrically connected to a conductive part on the mechanical part. Therefore, the connecting piece may be disposed on the circuit board, and the circuit board may be electrically connected to the conductive part on the mechanical part via the connecting piece, to implement conduction between the circuit board and the mechanical part.

In some implementations, the electronic device further includes a middle frame, the middle frame includes a middle plate and a bezel that are connected, and materials of the middle plate and the bezel are the mechanical part. The conductive part is disposed on the middle plate, and the connecting piece is disposed at a middle position of the circuit board and is electrically connected to the circuit board. The connecting piece on the circuit board is electrically connected to the conductive part on the middle plate. Therefore, the connecting piece may be disposed on the circuit board, and the middle plate may be provided with a conductive part corresponding to a position of the connecting piece, so that the middle plate and the circuit board can be conducted through an electrical connection between the connecting piece and the conductive part.

In some implementations, the electronic device further includes a middle frame, the middle frame includes a middle plate and a bezel that are connected, and materials of the middle plate and the bezel are the mechanical part. The conductive part is disposed on the bezel, and the connecting piece is disposed at an edge position of the circuit board and is electrically connected to the circuit board. The connecting piece on the circuit board is electrically connected to the conductive part on the bezel. Therefore, the connecting piece may be disposed on the circuit board, and the bezel may be provided with a conductive part corresponding to a position of the connecting piece, so that the bezel and the circuit board can be conducted through an electrical connection between the connecting piece and the conductive part.

In some implementations, the connecting piece is disposed on the mechanical part, and is electrically connected to the conductive part. The circuit board is electrically connected to the connecting piece on the mechanical part. Therefore, the connecting piece may alternatively be disposed on the mechanical part, and the circuit board may be electrically connected to the connecting piece on the mechanical part, to implement conduction between the circuit board and the mechanical part.

In some implementations, the electronic device further includes a middle frame, the middle frame includes a middle plate and a bezel that are connected, and materials of the middle plate and the bezel are the mechanical part. The conductive part is disposed on the middle plate, the connecting piece is disposed on the middle plate and is electrically connected to the conductive part, and the circuit board is electrically connected to the connecting piece on the middle plate. Therefore, the connecting piece may alternatively be disposed on the middle plate of the middle frame, so that the circuit board can be electrically connected to and conducted to the middle plate via the connecting piece.

In some implementations, the electronic device further includes a middle frame, the middle frame includes a middle plate and a bezel that are connected, and materials of the middle plate and the bezel are the mechanical part. The conductive part is disposed on the bezel, the connecting piece is disposed on the bezel and is electrically connected to the conductive part, and the circuit board is electrically connected to the connecting piece on the bezel. Therefore, the connecting piece may alternatively be disposed on the bezel of the middle frame, so that the circuit board can be electrically connected to and conducted to the bezel via the connecting piece.

### BRIEF DESCRIPTION OF DRAWINGS

FIG. 1 is a diagram of a three-dimensional structure of an electronic device according to an embodiment of this application;
FIG. 2 is a diagram of an exploded structure of the electronic device in FIG. 1;
FIG. 3 is a diagram of a three-dimensional structure of a middle frame of the electronic device in FIG. 2;
FIG. 4 is a diagram of a three-dimensional structure in which a part captured from the middle frame in FIG. 3 is used as a mechanical part;
FIG. 5 is a diagram of a planar structure of an arrangement manner of carbon fiber filaments in the mechanical part in FIG. 4;
FIG. 6 is a diagram of a three-dimensional structure of a mechanical part body in FIG. 4;
FIG. 7 is a diagram 1 of a cross-sectional structure of the mechanical part body in FIG. 6 along A-A;
FIG. 8 is a diagram 2 of a cross-sectional structure of the mechanical part body in FIG. 6 along A-A;
FIG. 9 is a diagram 3 of a cross-sectional structure of the mechanical part body in FIG. 6 along A-A;
FIG. 10 is a diagram 4 of a cross-sectional structure of the mechanical part body in FIG. 6 along A-A;
FIG. 11 is a diagram of a cross-sectional structure in which a groove of the mechanical part body in FIG. 9 is filled with a conductive part;
FIG. 12 is a diagram 1 of a three-dimensional structure in which a surface of a carbon fiber filament in FIG. 11 is roughened;
FIG. 13 is a diagram 2 of a three-dimensional structure in which a surface of a carbon fiber filament in FIG. 11 is roughened;
FIG. 14 is a diagram of an enlarged structure of a position A of the mechanical part body in FIG. 11;
FIG. 15 is a diagram of a cross-sectional structure in which a pad is disposed in a groove of the mechanical part body in FIG. 9;
FIG. 16 is a diagram of a three-dimensional structure in which a metal plating layer is plated on a surface of the mechanical part body in FIG. 9;
FIG. 17 is a diagram of a structure in which a carbon fiber filament and a graphene fiber are mixed and woven in the mechanical part in FIG. 16;
FIG. 18 is a diagram of a use status of an electronic device according to an embodiment of this application;
FIG. 19 is a diagram of a cross-sectional structure of a carbon fiberboard in the conventional technology;
FIG. 20 is a diagram 1 of a three-dimensional structure of a circuit board in the electronic device in FIG. 18;
FIG. 21 is a diagram of a cross-sectional structure of an electronic device including the circuit board in FIG. 20;
FIG. 22 is a diagram of an enlarged structure of a position B of the electronic device in FIG. 21;
FIG. 23 is a diagram 2 of a three-dimensional structure of a circuit board in the electronic device in FIG. 18;
FIG. 24 is a diagram of a cross-sectional structure of an electronic device including the circuit board in FIG. 23;
FIG. 25 is a diagram 1 of a three-dimensional structure of a mechanical part according to an embodiment of this application;
FIG. 26 is a diagram of a planar structure in which the mechanical part in FIG. 25 is used as a middle plate of an electronic device;
FIG. 27 is a diagram 2 of a three-dimensional structure of a mechanical part according to an embodiment of this application; and
FIG. 28 is a diagram of a three-dimensional structure in which a mechanical part is used in a notebook computer according to an embodiment of this application.

### Reference numerals:

01: electronic device; 02: mechanical part; 03: notebook computer; 100: middle frame; 200: display; 300: rear cover; 400: circuit board; 500: battery; 101: hollow part; 110: middle plate; 120: bezel; 121: bezel antenna; 122: slot; 123: slit; 130: local region; 210: mechanical part body; 220: conductive part; 211: carbon fiber filament; 212: insulation part; 213: groove; 2131: groove bottom; 2132: groove wall; 2133: groove space; 2134: partition wall; 211a: first section plane; 211b: second section plane; 211c: third section plane; 221: conductive layer; 222: base layer; 223: alloy region; 2111: dent; 2112: gap; 230: pad; 240: metal plating layer; 250: graphene; 410: substrate; 420: chip; 430: memory; 440: shielding cover; 450: connecting piece; 460: conducting wire; 451: conductive silicone; 452: conductive elastomer; 470: patch antenna; 480: ground point; 490: feed point; 210a: first wall surface; 210b: second wall surface; 310: computer body; 320: screen; 330: housing.

### DESCRIPTION OF EMBODIMENTS

To make objectives, technical solutions, and advantages of this application clearer, the following further describes this application in detail with reference to accompanying drawings.

Terms "first" and "second" mentioned below are merely intended for a purpose of description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more than two.

In addition, in this application, position terms such as "upper" and "lower" are defined relative to an illustrative position of a component in the accompanying drawings. It should be understood that these direction terms are relative concepts and are used for relative description and clarification, and may vary accordingly depending on a position change in which components are placed in the accompanying drawings.

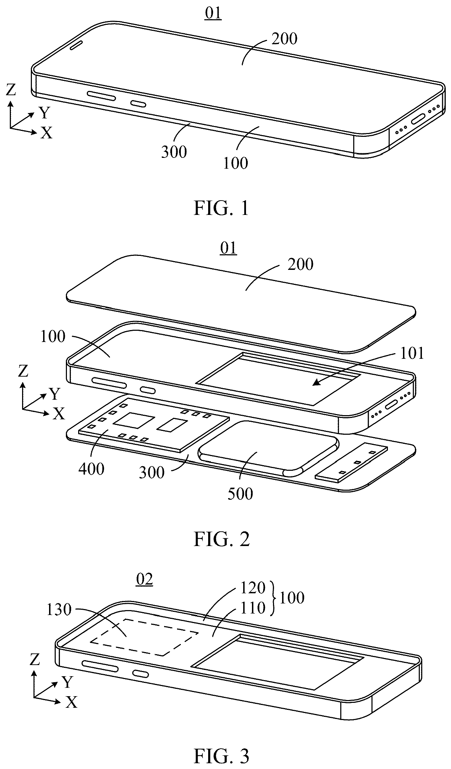

An embodiment of this application provides an electronic device 01. As shown in FIG. 1, the electronic device 01 may be an electronic product like a mobile phone, a tablet computer, an e-reader, a notebook computer, a wearable device, or an uncrewed aerial vehicle. A specific type of the electronic device 01 is not specially limited in embodiments of this application. To better display content in this embodiment of this application, the following uses an example in which the electronic device 01 is a mobile phone for description.

As shown in FIG. 1, the electronic device 01 may include a middle frame 100, a display 200, and a rear cover 300. The display 200 may be connected to one side of the middle frame 100 through pasting, and the rear cover 300 may be connected to one side that is of the middle frame 100 and that is away from the display 200 through screwing, welding, bonding, or snap-fit connection. A connection manner between components of the electronic device 01 is not specially limited in embodiments of this application. As shown in FIG. 1, the electronic device 01 may have a length direction, a width direction, and a thickness direction. For ease of description, in the following embodiments, an X direction is used as the length direction of the electronic device 01, a Y direction is used as the width direction of the electronic device 01, and a Z direction is used as the thickness direction of the electronic device 01. A mobile phone is used as an example. A contour of the mobile phone may be a rectangle, a direction of a long side may be a length direction of the mobile phone, and a direction of a short side may be a width direction of the mobile phone.

FIG. 2 is a diagram of an exploded structure of the electronic device 01. To implement a related function of the electronic device 01, the electronic device 01 may further include a circuit board 400 and a battery 500. The circuit board 400 may be electrically connected to electronic components such as a plurality of chips, memories, and antennas, and the battery 500 may be electrically connected to the circuit board 400, to provide a power supply required by the circuit board 400. Based on different structure designs of the electronic device 01, the circuit board 400 and the battery 500 may be installed between the middle frame 100 and the rear cover 300, or may be installed between the middle frame 100 and the display 200. Installation positions of the circuit board 400 and the battery 500 are not specially limited in embodiments of this application.

In addition, as shown in FIG. 2, to facilitate installation of the battery 500, a hollow part 101 may be further disposed on the middle frame 100, so that the battery 500 can be installed at the hollow part 101. An internal structure of the electronic device 01 is not specially limited in embodiments of this application. In the following embodiments, for ease of description, hollow components such as grooves and holes are marked by leader lines with arrows, and other components are marked by leader lines without arrows. A same annotation manner is used in the accompanying drawings of the following embodiments, and details are not described again.

To reduce a structural weight of the electronic device 01, an embodiment of this application provides a mechanical part 02. For example, the middle frame 100 of the electronic device 01 may use the mechanical part 02 provided in this embodiment of this application. FIG. 3 is a diagram of a three-dimensional structure of the middle frame 100 in the electronic device 01 in FIG. 2. The middle frame 100 may include a middle plate 110 and a bezel 120, and the bezel 120 may be connected to a periphery of the middle plate 110. The middle plate 110 and the bezel 120 may be made of a carbon fiber composite material. The middle plate 110 and the bezel 120 may be an integrally formed mechanical part 02, or may be a mechanical part 02 formed through bonding, screwing, or riveting. To better display a specific structure of the mechanical part 02, the following provides detailed descriptions by capturing a local region 130 of the middle plate 110 as the mechanical part 02 in a region shown by a dashed line in FIG. 2.

In addition, the bezel 120 of the middle frame 100 may alternatively use a same structure and material as the mechanical part 02, and the rear cover 300 of the electronic device 01 may alternatively use a same structure and material as the mechanical part 02. A specific structure part of the electronic device 01 at which the mechanical part 02 may be used is not specially limited in embodiments of this application. The following merely uses the middle plate 110 as an example to describe a structure of the mechanical part 02 in the captured local region 130.

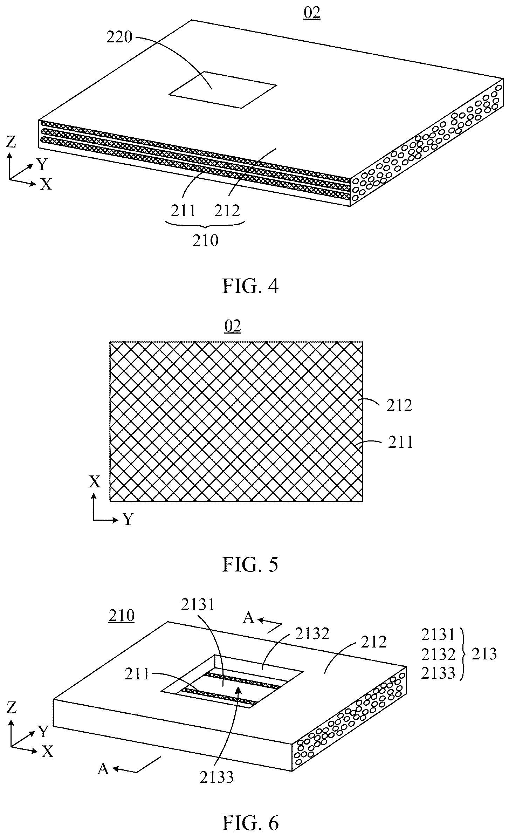

Based on this, FIG. 4 is a diagram of an enlarged structure of the captured local region 130 of the middle plate 110 in FIG. 3. The mechanical part 02 provided in this embodiment of this application may include a mechanical part body 210 and a conductive part 220. The conductive part 220 is disposed on the mechanical part body 210, and is connected to the mechanical part body 210. The mechanical part body 210 may include a carbon fiber filament 211 and an insulation part 212. The carbon fiber filament 211 is embedded in the insulation part 212, and a part of the carbon fiber filament 211 may be exposed outside the insulation part 212 through slotting, cutting a hole, or the like. In this way, the carbon fiber filament 211 may be in contact with and electrically connected to the conductive part 220, and the carbon fiber filament 211 and the conductive part 220 are conducted, so that the conductive part 220 may be used as a welding joint on the mechanical part 02, and is configured to be connected to at least one of the circuit board 400 (shown in FIG. 2) and the battery 500 (shown in FIG. 2). The insulation part 212 may be an insulation material like resin or ceramics, and the carbon fiber filament 211 may be embedded in the insulation part 212 through processes such as adhesive coating and compression molding. A specific material of the insulation part 212 and a manufacturing process of the mechanical part body 210 are not specially limited in embodiments of this application. In some implementations, as shown in FIG. 4, a plurality of carbon fiber filaments 211 may be disposed, the plurality of carbon fiber filaments 211 may be disposed in the X direction and arranged in the Y direction, and the plurality of carbon fiber filaments 211 may alternatively be disposed in a layered manner in the Z direction. In some other implementations, as shown in FIG. 5, the plurality of carbon fiber filaments 211 may alternatively be arranged in a mesh shape in the XY plane. A specific quantity and an arrangement manner of the carbon fiber filaments 211 in the insulation part 212 are not specially limited in embodiments of this application.

A spacing between the carbon fiber filaments 211 shown in FIG. 4 and FIG. 5 does not represent an actual spacing between the carbon fiber filaments 211 in the carbon fiber composite material, and is merely used as an example of a specific arrangement manner of the carbon fiber filaments 211 in the insulation part 212. Density of carbon fiber filaments 211 in an actual carbon fiber composite material is far greater than density shown in the figure. When the density of the carbon fiber filaments 211 is large, during processes of adhesive coating and compression molding of the carbon fiber composite material, the carbon fiber filaments 211 are overlapped, wound, or parallel to each other, so that the carbon fiber filaments 211 in the carbon fiber composite material can be conducted to each other. In addition, the density of the carbon fiber filaments 211 is large, and a spacing between the carbon fiber filaments 211 is small. Therefore, indirect coupling still exists between the carbon fiber filaments 211. Similarly, the carbon fiber filaments 211 in the carbon fiber composite material can be conducted to each other.

Based on this, an embodiment of this application provides a mechanical part 02. FIG. 6 shows a structure of the mechanical part 02 before the conductive part 220 is disposed. For example, a groove 213 may be disposed on a surface of the mechanical part body 210, so that the part of the carbon fiber filament 211 is exposed in the groove 213. The groove 213 may include a groove bottom 2131, a groove wall 2132, and groove space 2133 enclosed by the groove bottom 2131 and the groove wall 2132. The carbon fiber filament 211 exposed in the groove 213 may be located on the groove bottom 2131, or may be located on the groove wall 2132, or may be located in the groove space 2133. A specific position of the carbon fiber filament 211 exposed in the groove 213 is not specially limited in embodiments of this application.

The groove 213 may be disposed according to process methods like computer numerical control (Computer Numerical Control, CNC), polishing, grinding, and wire drawing via a mechanical device, and the groove 213 may alternatively be disposed in the surface of the mechanical part body 210 according to a method like ion beam etching or photolithography. Certainly, grooves 213 of different shapes may be disposed in the surface of the mechanical part body 210 through different processing techniques. For example, the rectangular groove 213 may be formed through processing like a CNC process. A processing technique and a specific shape of the groove 213 are not specially limited in embodiments of this application. For better description, the shape of the groove 213 and the carbon fiber filament 211 exposed in the groove 213 are described by using examples in the following embodiments.

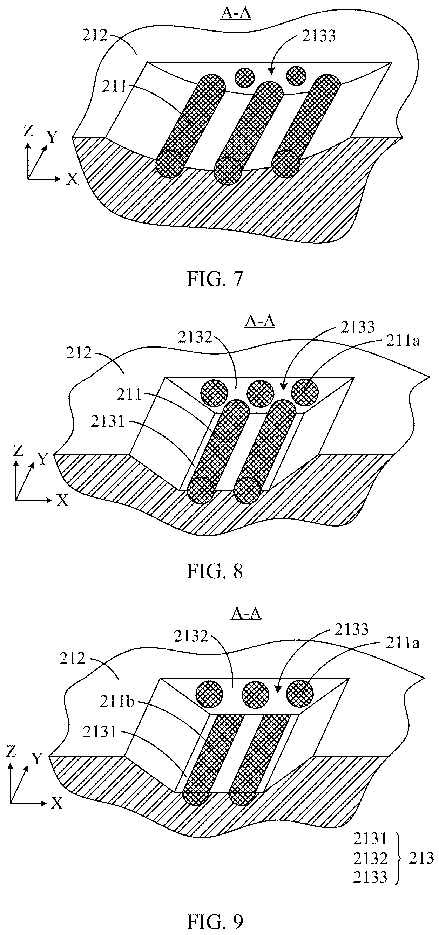

For example, as shown in FIG. 7, the groove 213 (shown in FIG. 6) may be set to an arc shape through ion beam etching or photolithography. Certainly, based on different processing techniques, the carbon fiber filament 211 exposed in the groove 213 may be presented as a cylindrical curved surface, or may be presented as a truncated cross-sectional shape, provided that there is the exposed carbon fiber filament 211 in the groove 213. A specific shape of the exposed carbon fiber filament 211 in the groove 213 is not specially limited in embodiments of this application.

For example, as shown in FIG. 8, a shape of the groove 213 (shown in FIG. 6) may alternatively be a trapezoid. In some implementations, the foregoing processing technique may be used to remove only the insulation part 212 in the groove 213, and retain the carbon fiber filament 211 located on the groove bottom 2131. Therefore, an outer surface of the carbon fiber filament 211 located on the groove bottom 2131 may protrude from the groove bottom 2131, and the conductive part 220 may be in contact with and electrically connected to the outer surface of the carbon fiber filament 211 protruding from the groove bottom 2131. In some other implementations, the carbon fiber filament 211 and the insulation part 212 in the groove 213 may be removed at the same time by using the foregoing processing technique, so that the carbon fiber filament 211 located on the groove wall 2132 may have a first section plane 211a, and the first section plane 211a may be flush with the groove wall 2132. In this way, the conductive part 220 may further be in contact with and electrically connected to the first section plane 211a of the carbon fiber filament 211 on the groove wall 2132. Certainly, a combination of the foregoing processing techniques may alternatively be used, so that the carbon fiber filament 211 exposed in the groove 213 has both an outer surface protruding from the groove bottom 2131 and the first section plane 211a flush with the groove wall 2132.

For example, as shown in FIG. 9, a remaining structure is the same as the structure shown in FIG. 8. A difference lies in that the carbon fiber filament 211 and the insulation part 212 in the groove 213 (shown in FIG. 6) may be removed through the foregoing processing technique, the carbon fiber filament 211 located on the groove bottom 2131 may have a second section plane 211b, and the second section plane 211b may be flush with the groove bottom 2131. In this way, the conductive part 220 may further be in contact with and electrically connected to the second section plane 211b of the carbon fiber filament 211 on the groove bottom 2131. Alternatively, a combination of the foregoing processing techniques may be used, so that the carbon fiber filament 211 exposed in the groove 213 has both the second section plane 211b flush with the groove bottom 2131 and the first section plane 211a flush with the groove wall 2132.

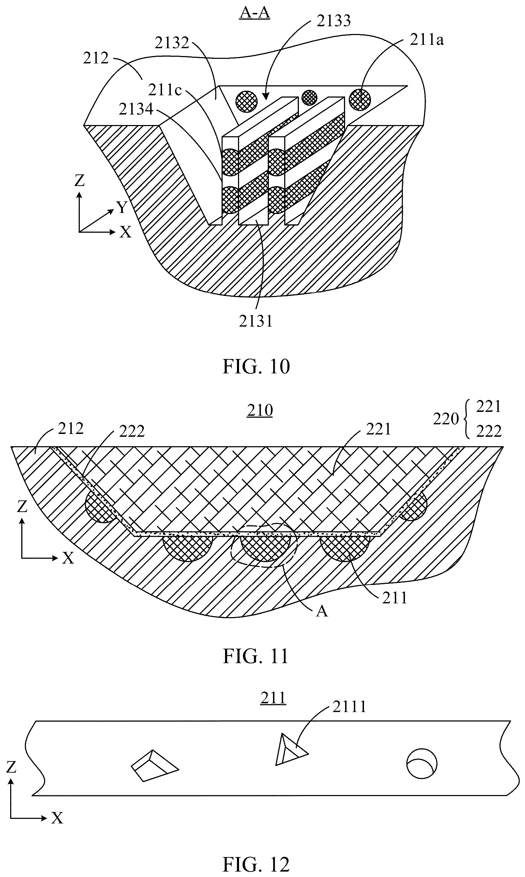

For example, as shown in FIG. 10, a part of the carbon fiber filament 211 and a part of the insulation part 212 in the groove 213 (shown in FIG. 6) may be removed simultaneously through the foregoing processing technique, the remaining carbon fiber filament 211 and the insulation part 212 form a partition wall 2134 connected to the groove bottom 2131, and the partition wall 2134 may be spaced from the groove wall 2132. The partition wall 2134 may include the carbon fiber filament 211 and the insulation part 212. The carbon fiber filament 211 on the partition wall 2134 may have a third section plane 211c, and the third section plane 211c may be flush with a side wall of the partition wall 2134. Therefore, the conductive part 220 may further be in contact with and electrically connected to the third section plane 211c of the carbon fiber filament 211 on the side wall of the partition wall 2134. In this case, the exposed carbon fiber filament 211 is located in the groove space 2133. Certainly, there may be a plurality of partition walls 2134 on the groove bottom 2131. A specific quantity of partition walls 2134 is not specially limited in embodiments of this application.

Certainly, to enable the part of the carbon fiber filament 211 embedded in the insulation part 212 to be exposed outside the insulation part 212, the part of the carbon fiber filament 211 may also be enabled to protrude from the surface of the mechanical part body 210 when the mechanical part body 210 is manufactured. In other words, the carbon fiber filament 211 and the insulation part 212 that protrude relative to the surface of the mechanical part body 210 are disposed on the surface of the mechanical part body 210. For example, a multi-layer carbon fiber filament 211 structure may be used in a part of the mechanical part body 210, so that the carbon fiber filament 211 in the part protrudes from the surface of the mechanical part body 210 after adhesive coating or compression molding. In this case, the insulation part 212 protruding from the surface of the mechanical part body 210 can be directly removed according to a method like CNC, polishing, grinding, wire drawing, ion beam etching, or photolithography, so that the groove 213 does not need to be disposed on the surface of the mechanical part body 210. Similarly, the part of the carbon fiber filament 211 embedded in the insulation part 212 can be exposed outside the insulation part 212.

The foregoing embodiment uses an example to describe a specific shape of the groove 213 and the carbon fiber filament 211 exposed in the groove 213. The following describes in detail the conductive part 220 disposed in the groove 213. As shown in FIG. 11, the conductive part 220 may include a conductive layer 221 and a base layer 222. The base layer 222 is disposed in the groove 213 (shown in FIG. 9), and the base layer 222 is directly connected to the carbon fiber filament 211 exposed in the groove 213. The base layer 222 may be plated in the groove 213 through electroplating, electroless plating, or the like, so that the base layer 222 is directly connected to the carbon fiber filament 211. There may be one or more layers of the base layer 222. A quantity of layers of the base layer 222 is not specially limited in embodiments of this application. The conductive layer 221 is filled in the groove 213, and the conductive layer 221 is connected to the base layer 222.

In addition, in more implementations, in the Z direction, a surface of the conductive part 220 may protrude from a surface of the insulation part 212, or may be flush with the surface of the insulation part 212, or may be lower than the surface of the insulation part 212. A surface height of the conductive part 220 in the Z direction is not specially limited in embodiments of this application.

To ensure connection strength between the base layer 222 and the carbon fiber filament 211 exposed in the groove 213, roughening may be performed on a surface of the carbon fiber filament 211 exposed in the groove 213, so that the surface of the carbon fiber filament 211 is uneven, to increase a specific surface area of the carbon fiber filament 211, thereby improving connection strength between the base layer 222 (shown in FIG. 11) and the carbon fiber filament 211. A manner of roughening may be liquid phase oxidation etching, plasma processing, irradiation processing, or the like. A specific manner of roughening is not specially limited in embodiments of this application. A surface of roughened carbon fiber filament 211 may be the outer surface of the carbon fiber filament 211 protruding from the groove bottom 2131 shown in FIG. 8, or may be the first section plane 211a flush with the groove wall 2132 shown in FIG. 8, or the second section plane 211b flush with the groove bottom 2131 shown in FIG. 9, or may be the third section plane 211c on the side wall of the partition wall 2134 shown in FIG. 10.

In some implementations, as shown in FIG. 12, during roughening, a dent 2111 may be formed on the surface of the carbon fiber filament 211 through different roughening processing techniques, and a shape of the dent 2111 may be various different shapes such as a triangle, a circle, and a rectangle. A specific shape and depth of the dent 2111 are not specially limited in embodiments of this application. The base layer 222 (shown in FIG. 11) may be embedded into the dent 2111, which not only increases a connection area between the carbon fiber filament 211 and the base layer 222, but also increases occlusion force between the base layer 222 and the carbon fiber filament 211. This improves bonding strength between the base layer 222 and the carbon fiber filament 211. An area of the dent 2111 disposed on the surface of the carbon fiber filament 211 may be 1 µm² to 1 mm², and a depth of the dent 2111 disposed on the surface of the carbon fiber filament 211 may be 1 µm to 1000 µm. If a size of the dent 2111 is excessively large, the specific surface area of the carbon fiber filament 211 is reduced. This affects bonding strength between the base layer 222 and the carbon fiber filament 211. If a size of the dent 2111 is excessively small, the base layer 222 cannot be embedded into the dent 2111. This also affects bonding strength between the base layer 222 and the carbon fiber filament 211.

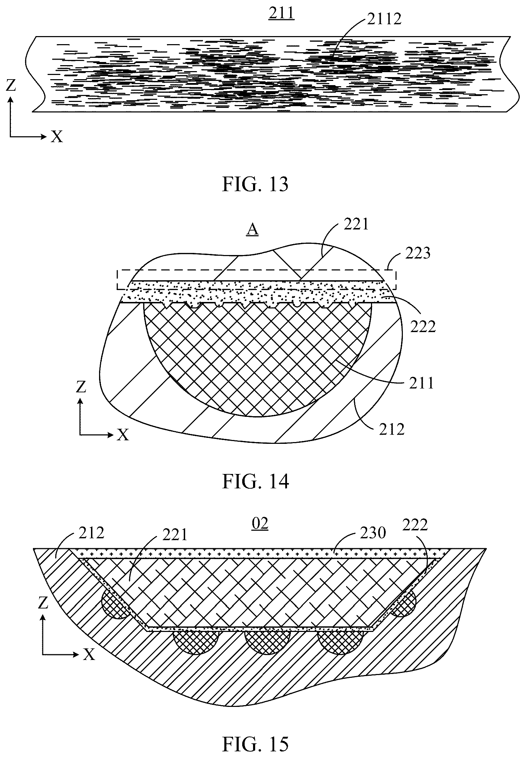

In some other implementations, as shown in FIG. 13, during roughening, dense gaps 2112 may be further formed on the surface of the carbon fiber filament 211 through different roughening processing techniques. A density degree of the gaps 2112 is not specially limited in embodiments of this application. Similarly, the base layer 222 (shown in FIG. 11) may be further embedded into the gap 2112, to improve bonding strength between the base layer 222 and the carbon fiber filament 211. Each of a length, a width, and a depth of the gap 2112 disposed on the surface of the carbon fiber filament 211 may be 1 µm to 1000 µm. If a size of the gap 2112 is excessively large, the specific surface area of the carbon fiber filament 211 is also reduced. This affects bonding strength between the base layer 222 and the carbon fiber filament 211. If a size of the gap 2112 is excessively small, the base layer 222 cannot be embedded into the gap 2112. This also affects bonding strength between the base layer 222 and the carbon fiber filament 211.

Based on this, FIG. 14 is a diagram of an enlarged structure of a position A in FIG. 11. For example, a material of the conductive layer 221 may be metal tin with a low melting point, and the metal tin with a low melting point may fill the groove 213 (shown in FIG. 9) in a liquid state. In this case, connection strength between the conductive layer 221 and the groove 213 can be prevented from being affected by a gap between the conductive layer 221 and the groove 213. After the metal tin is cured, a welding surface can be formed on a side away from the base layer 222, and is used as a welding joint. The base layer 222 may use metal chromium, and the metal tin in the liquid state may be fused with the metal chromium to form alloy. In other words, an alloy region 223 shown by the dashed line in the figure may be formed at an interface between the conductive layer 221 and the base layer 222. This improves bonding strength between the conductive layer 221 and the base layer 222.

Certainly, the material of the conductive layer 221 may alternatively be gallium, bismuth, indium, or another metal with a low melting point, and a material of the base layer 222 may alternatively be metal like titanium, nickel, copper, iron, or aluminum or alloy thereof. Similarly, alloy may be formed at the interface between the conductive layer 221 and the base layer 222. A melting point of the metal may be 50°C to 350°C. If the melting point of the metal is excessively high, it is difficult to fuse the metal with the base layer 222 to form alloy, and the insulation part 212 is easily oxidized. If the melting point of the metal is excessively low, stability of the alloy is affected. Specific materials of the conductive layer 221 and the base layer 222 are not specially limited in embodiments of this application.

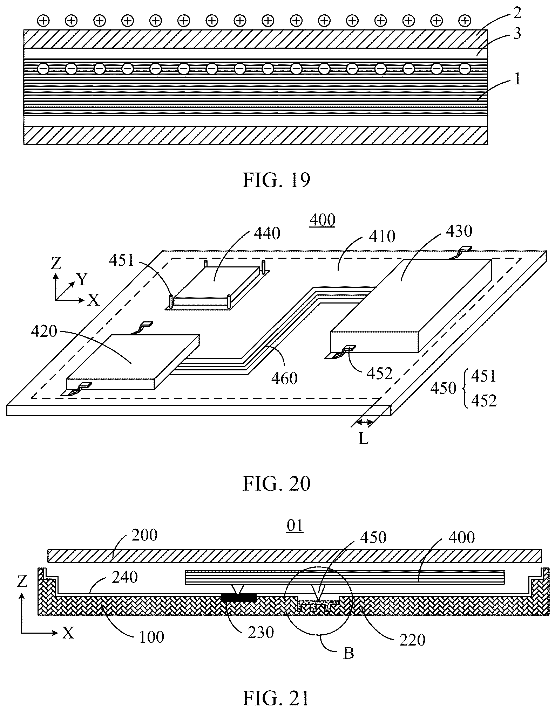

In addition, as shown in FIG. 15, the mechanical part 02 may further include a connecting piece 450 (shown in FIG. 20). In some implementations, the connecting piece 450 may include a pad 230. The pad 230 may be disposed on a side that is of the conductive layer 221 and that is away from the base layer 222, and the pad 230 is electrically connected to the conductive layer 221, so that the mechanical part 02 can be electrically connected to another electronic component via the pad 230. The conductive layer 221 may be partially filled in the groove 213 (shown in FIG. 9), so that the pad 230 is flush with the surface of the insulation part 212. The conductive layer 221 may alternatively be completely filled with the groove 213, so that the pad 230 protrudes from the surface of the insulation part 212. A relative position relationship between the pad 230 and the insulation part 212 is not specially limited in embodiments of this application.

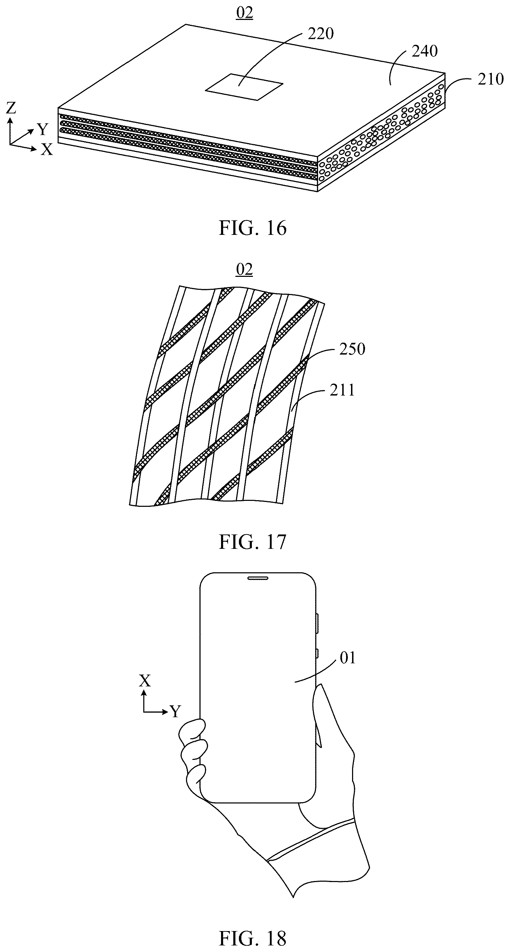

In some implementations, as shown in FIG. 16, the mechanical part 02 may further include a metal plating layer 240. The metal plating layer 240 is plated on the outer surface of the mechanical part body 210, and the conductive part 220 may be electrically connected to the metal plating layer 240. In the Z direction in the figure, the conductive part 220 may be flush with a surface of the metal plating layer 240, or the conductive part 220 may protrude or be concave relative to the surface of the metal plating layer 240. A relative position relationship between the conductive part 220 and the metal plating layer 240 is not specially limited in embodiments of this application. For example, when the mechanical part 02 is used as the middle frame 100 (shown in FIG. 2) of the electronic device 01 (shown in FIG. 2), the mechanical part body 210 may be plated with the metal plating layer 240 on both sides. When the mechanical part 02 is used as the rear cover 300 of the electronic device 01 (shown in FIG. 2), the mechanical part body 210 may alternatively be plated with the metal plating layer 240 on one side. A position and a quantity of the metal plating layers 240 are not specially limited in embodiments of this application.

Considering a heat dissipation requirement of the electronic device 01 (shown in FIG. 2), the mechanical part body 210 of the mechanical part 02 may further include graphene 250. In some implementations, as shown in FIG. 17, the graphene 250 may be configured as a graphene fiber, and the graphene fiber may be mixed and woven with the carbon fiber filament 211. In some other implementations, the graphene 250 may alternatively be configured as graphene powder, and the graphene powder may be integrally hot-pressed with the carbon fiber filament 211 before being embedded into the insulation part 212 (shown in FIG. 15), or may be in-situ composite molded with the carbon fiber filament 211 in a process of embedding the insulation part 212. A specific manner of compounding the graphene 250 and the carbon fiber filament 211 is not specially limited in embodiments of this application. In this way, the mechanical part 02 can be further used as a good heat-conducting medium.

In the foregoing embodiment, based on different scenarios of the mechanical part 02, environments in which the carbon fiber filament 211 exposed outside the insulation part 212 is located are different. For example, when the groove 213 is disposed according to methods like CNC, polishing, grinding, and wire drawing, the carbon fiber filament 211 exposed outside the insulation part 212 may be a carbon fiber filament 211 that is in the groove 213 and that is in contact with air. When the groove 213 is disposed according to a method like ion beam etching or photolithography, because protective gas is required in a processing process, the carbon fiber filament 211 exposed outside the insulation part 212 may be a carbon fiber filament 211 that is in contact with the protective gas in the groove 213. After the groove 213 is filled with the conductive part 220, the carbon fiber filament 211 exposed outside the insulation part 212 may be a carbon fiber filament 211 that is in the groove 213 and that is in contact with and electrically connected to the conductive part 220.

In the foregoing embodiment, a specific structure of the mechanical part 02 is described in detail by using an example in which the mechanical part 02 is used as the middle frame 100 of the electronic device 01. The following describes in detail a working principle of the middle frame 100 with reference to a specific structure of the mechanical part 02. As shown in FIG. 18, to reduce a weight of the electronic device 01, a carbon fiber composite board with high strength, a light weight, and good flexibility is usually selected as the middle frame 100 (shown in FIG. 2) or the rear cover 300 (shown in FIG. 2) of the electronic device 01.

Because the carbon fiber has a characteristic of absorbing an electromagnetic wave, and a carbon fiber composite material formed by combining the carbon fiber and an insulation material has a hysteresis characteristic, the carbon fiber composite material has problems of selfabsorption and passive inter-modulation (passive inter-modulation, PIM). To resolve this problem, as shown in FIG. 19, a surface of a carbon fiber composite board 1 is usually coated with metal 2, and there is an insulation 3 between the carbon fiber composite board 1 and the metal 2. Static electricity is easily generated when a human body moves. When the electronic device 01 is held, the static electricity is transmitted to the electronic device 01. When a large current (for example, static electricity) passes through the metal 2, a type of charge (for example, a positive charge) is generated on a surface of the metal 2. In this case, because the carbon fiber in the carbon fiber composite board 1 has good conductivity, the carbon fiber can generate another type of charge (for example, a negative charge) through electrostatic induction. In this way, as the electronic device 01 is frequently used, the carbon fibers in the carbon fiber composite board 1 continuously accumulate charges. Because the carbon fiber is plastically packaged in the insulation 3, and cannot be discharged outwards, when electric charges accumulate to a specific threshold, the electric charges are directly released to a nearest electronic component. As a result, the electronic component in the electronic device 01 is burnt out.

Based on the mechanical part 02 provided in this embodiment of this application, as shown in FIG. 11, the groove 213 (shown in FIG. 9) is disposed on the surface of the mechanical part body 210, and the part of the carbon fiber filament 211 is exposed in the groove 213 and is in direct contact with the carbon fiber filament 211 via the conductive part 220. In this way, the conductive part 220 in the groove 213 can be directly conducted to the carbon fiber filament 211 exposed in the groove 213, so that the carbon fiber filament 211 plastically packaged in the insulation part 212 may be used as a discharge path of the electrostatic current. For example, as shown in FIG. 16, when the metal plating layer 240 is plated on the outer surface of the mechanical part body 210, the metal plating layer 240 may be used as a reference ground. Because the conductive part 220 is electrically connected to the metal plating layer 240, the electrostatic current can finally flow to the metal plating layer 240 through the carbon fiber filament 211 and the conductive part 220, to avoid an ESD problem caused by a lack of a discharge path of the electrostatic current.

In addition, as shown in FIG. 14 in the foregoing embodiment, because the surface of the carbon fiber filament 211 exposed in the groove 213 is roughened, bonding strength between the base layer 222 and the carbon fiber filament 211 is improved. In addition, because the conductive layer 221 made of the metal material with a low melting point can be fused with the base layer 222 in a liquid state to form alloy, bonding strength between the conductive layer 221 and the base layer 222 is improved, and a three-layer force-bearing structure including the carbon fiber filament 211, the base layer 222, and the conductive layer 221 is formed. When the metal plating layer 240 is plated on the outer surface of the mechanical part body 210, connection strength of the metal plating layer 240 on the mechanical part body 210 may be improved by welding the conductive layer 221 to the metal plating layer 240, so that a problem that the metal plating layer 240 falls off from the mechanical part body 210 when a temperature fluctuates greatly due to different coefficients of thermal expansion between the metal plating layer 240 and the mechanical part body 210 is avoided.

To better demonstrate application of the mechanical part 02 provided in this embodiment of this application in the electronic device 01, in some implementations, as shown in FIG. 20, the circuit board 400 in the electronic device 01 may include electronic components such as a substrate 410, a chip 420, a memory 430, a shielding cover 440, a plurality of connecting pieces 450, and a conducting wire 460. The conducting wire 460 is disposed on the substrate 410. The chip 420, the memory 430, and the shielding cover 440 may be electrically connected to a surface of the substrate 410 through a surface mount technology (surface mount technology, SMT). In addition, the chip 420 and the memory 430 may be electrically connected through the conducting wire 460.

Certainly, based on different function requirements of the electronic device 01, the circuit board 400 may further include other electronic components such as a fingerprint module, a camera module, and a microphone. The electronic components may be separately electrically connected to the circuit board 400, or may be electrically connected to each other through the conducting wire 460. A type, a quantity, and a connection manner of electronic components on the circuit board 400 are not specially limited in embodiments of this application.

Still refer to FIG. 20. Generally, to determine an operating voltage of each electronic component, each electronic component is electrically connected to the reference ground via the connecting piece 450. For example, the connecting piece 450 may be disposed on the circuit board 400, and is electrically connected to the circuit board 400. The connecting piece 450 may include conductive silicone 451 and a conductive elastomer 452. For example, the conductive silicone 451 may be disposed on a periphery of the shielding cover 440 to provide grounding for the shielding cover 440. The conductive elastomer 452 may be disposed on a periphery of the chip 420 and the memory 430 to provide grounding for the chip 420 and the memory 430. Certainly, different types of connecting pieces 450 may be selected for grounding of different electronic components. In addition, the connecting piece 450 and the electronic component may be disposed on a same side surface of the circuit board 400, or may be disposed on different side surfaces of the circuit board 400. A type of the connecting piece 450 selected for grounding of the electronic component and a disposing position of the connecting piece 450 are not specially limited in embodiments of this application.

The metal plating layer 240 in the mechanical part 02 (shown in FIG. 16) in the foregoing embodiment may be used as a reference ground. As shown in FIG. 21, the circuit board 400 may be disposed between the middle frame 100 and the display 200 of the electronic device 01, and the connecting piece 450 on the circuit board 400 may be welded to the conductive part 220 on the middle frame 100. Because the conductive part 220 is electrically connected to the metal plating layer 240, the electronic component on the circuit board 400 may be grounded via the connecting piece 450. For example, in the Z direction in the figure, the surface of the conductive part 220 is lower than a surface that is of the middle frame 100 and that faces the circuit board 400, so that the metal plating layer 240 can be electrically connected to the conductive part 220 in the groove 213 (shown in FIG. 6). Therefore, a thickness of the metal plating layer 240 in the Z direction at the position of the conductive part 220 is increased. During welding, a problem that the metal plating layer 240 is detached from the conductive part 220 after welding because the metal plating layer 240 is excessively thin is avoided. This ensures welding quality.

Certainly, as shown in FIG. 21, in the Z direction in the figure, the pad 230 may alternatively be disposed on the surface of the conductive part 220. The pad 230 is electrically connected to the conductive part 220, and the pad 230 may alternatively be electrically connected to the metal plating layer 240. Therefore, the connecting piece 450 may be further electrically connected to the middle frame 100 via the pad 230. Whether the pad 230 is disposed at a position of the conductive part 220 on the middle frame 100 is not specially limited in embodiments of this application.

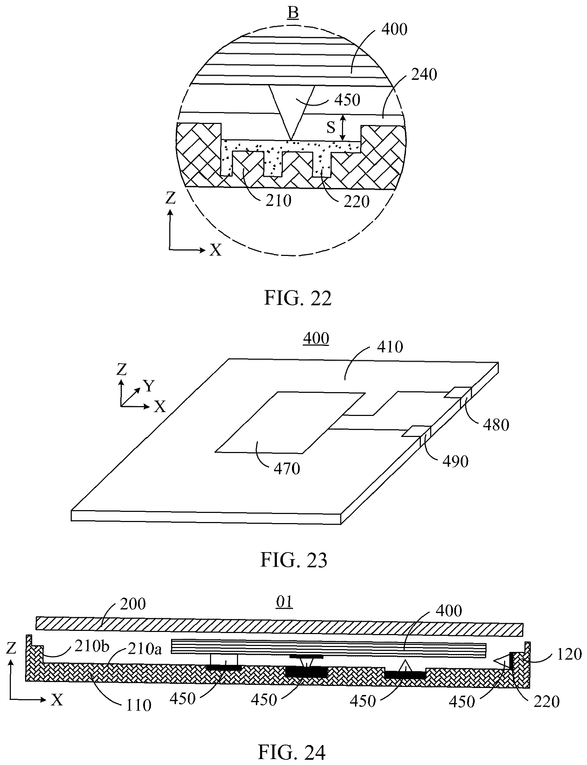

FIG. 22 is a diagram of an enlarged structure of a position B in FIG. 21. Different distances S between the metal plating layer 240 and the conductive part 220 may be set based on different heights of the connecting piece 450 in the Z direction, so that a depth of the groove 213 on the mechanical part body 210 can accommodate the connecting piece 450, to reduce a thickness of the electronic device 01 in the Z direction. This helps implement a light and thin design of the electronic device 01. In addition, when the conductive part 220 is used as a point for electrical connection to the circuit board 400, because the conductive part 220 forms the three-layer force-bearing structure including the carbon fiber filament 211, the base layer 222, and the conductive layer 221, when the conductive part 220 is welded, the conductive part 220 can withstand highvoltage and strong point contact of the connecting piece 450 and is not prone to welding joint damage. This ensures welding quality between the mechanical part body 210 and the circuit board 400.

For example, as shown in FIG. 20 and FIG. 21, the conductive part 220 may be disposed on the middle plate 110 (shown in FIG. 3) of the middle frame 100, and the connecting piece 450 may be disposed at a middle position of the circuit board 400, and is electrically connected to the circuit board 400. The middle position of the circuit board 400 may be a region outside a range of L from an edge of the circuit board 400, where 0 ≤ L ≤ 1 cm. The middle position and an edge position of the circuit board 400 are not specially limited in embodiments of this application. In this way, the circuit board 400 may be electrically connected to the conductive part 220 on the middle plate 110 via the connecting piece 450. Certainly, the connecting piece 450 may alternatively be disposed on the middle plate 110, and the connecting piece 450 is electrically connected to the conductive part 220 on the middle plate 110, so that the middle plate 110 can be electrically connected to the middle position of the circuit board 400 via the connecting piece 450. That the connecting piece 450 is disposed on the middle plate 110 or the circuit board 400 is not specifically limited in embodiments of this application.

In some implementations, as shown in FIG. 23, the electronic component on the circuit board 400 may also include a patch antenna 470, a ground point 480, and a feed point 490. The patch antenna 470 is electrically connected to the ground point 480 and the feed point 490. The ground point 480 and the feed point 490 may be disposed at the edge position of the circuit board 400. Certainly, based on requirements of different functions of the antenna, more patch antennas 470, ground points 480, and feed points 490 may be disposed on the circuit board 400. Specific quantities of patch antennas 470, ground points 480, and feed points 490 on the circuit board 400 are not specially limited in embodiments of this application.

Based on this, as shown in FIG. 24, the conductive part 220 in the foregoing embodiment may be disposed not only on the middle plate 110 of the middle frame 100, but also on the bezel 120 of the middle frame 100. For example, the conductive part 220 may be disposed on an inner side wall of the bezel 120, and the connecting piece 450 may be disposed on the inner side wall of the bezel 120 and is electrically connected to the conductive part 220. Certainly, there may be a plurality of connecting pieces 450 disposed on the inner side wall of the bezel 120. A specific quantity of connecting pieces 450 on the bezel 120 is not specially limited in embodiments of this application. In addition, the connecting piece 450 and the circuit board 400 may be in point contact or surface contact. The connecting piece 450 may be disposed on the circuit board 400, or may be disposed on the middle plate 110 or the bezel 120. A contact form and disposing positions of the connecting piece 450 and the circuit board 400 are not specially limited in embodiments of this application.

For example, as shown in FIG. 23 and FIG. 24, the conductive part 220 may be disposed on the bezel 120, the connecting piece 450 may be disposed on the bezel 120 and is electrically connected to the conductive part 220, and the bezel 120 may be electrically connected to the edge position of the circuit board 400 via the connecting piece 450. The edge position of the circuit board 400 is a region within a range of L from an edge of the circuit board 400, where 0 ≤ L ≤ 1 cm. In addition, the connecting piece 450 may alternatively be disposed at the edge position of the circuit board 400, and is electrically connected to the circuit board 400, so that the circuit board 400 can be electrically connected to the conductive part 220 on the bezel 120 via the connecting piece 450. That the connecting piece 450 is disposed on the bezel 120 or the circuit board 400 is not specifically limited in embodiments of this application.

In some implementations, as shown in FIG. 23, the ground point 480 and the feed point 490 may be disposed at the edge position of the circuit board 400, so that the ground point 480 and the feed point 490 may be separately electrically connected to the connecting piece 450 on the inner side wall of the bezel 120. In this way, a line grounding function of the patch antenna 470 is implemented. In addition, when there are electronic components such as a data interface, a fingerprint module, and a microphone on a side surface of the electronic device 01, a grounding function of the electronic components such as the data interface, the fingerprint module, and the microphone may also be implemented by disposing the connecting piece 450 on the bezel 120. The electronic component on the side surface of the electronic device 01 is not specially limited in embodiments of this application.

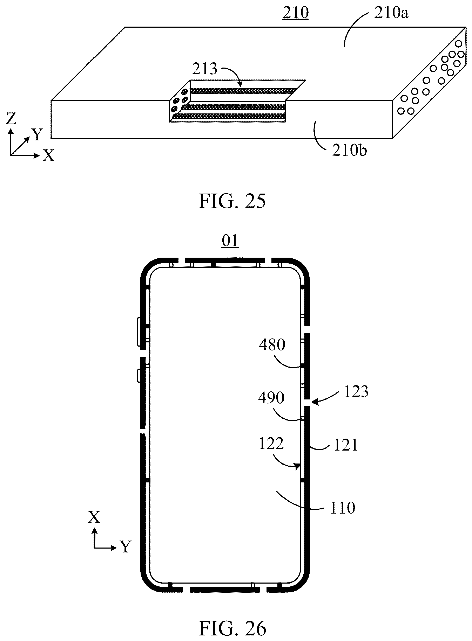

For example, as shown in FIG. 24, when a shape of the mechanical part body 210 is designed to be a shape of the middle frame 100 (shown in FIG. 3) in the foregoing embodiment, the mechanical part body 210 may include a first wall surface 210a and a second wall surface 210b that are connected. In this case, the first wall surface 210a may be a wall surface on a side that is of the middle plate 110 and that faces the circuit board 400, and the second wall surface 210b may be a wall surface on a side that is of the bezel 120 and that faces the circuit board 400. In addition, as shown in FIG. 25, the mechanical part body 210 may alternatively be designed as a plate structure. In this case, the first wall surface 210a may be a plate surface of the plate structure, and the second wall surface 210b may be a side surface of the plate structure. A part of the groove 213 in the foregoing embodiment may be disposed on the first wall surface 210a, and the other part may be disposed on the second wall surface 210b. Certainly, when a thickness of the mechanical part body 210 in the Z direction is large enough, the groove 213 may alternatively be completely disposed on the second wall surface 210b. A specific shape of the mechanical part body 210 and a disposing position of the groove 213 are not specially limited in embodiments of this application.

Based on this, as shown in FIG. 26, the electronic device 01 may further include the middle plate 110, a bezel antenna 121 made of a metal material, a plurality of ground points 480 and feed points 490. A slot 122 may be disposed between the middle plate 110 and the bezel antenna 121, a slit 123 for disconnecting the bezel antenna 121 may be disposed on the bezel antenna 121, and the plurality of ground points 480 and feed points 490 are disposed between the middle plate 110 and the bezel antenna 121. As shown in FIG. 25, the conductive part 220 (shown in FIG. 16) may be disposed in the groove 213 provided on the second wall surface 210b of the mechanical part body 210. In this way, when the mechanical part body 210 is used as the middle plate 110, a plurality of conductive parts 220 may be disposed on a side wall of the middle plate 110, so that the plurality of ground points 480 and feed points 490 may be electrically connected to the conductive parts 220, to implement a grounding function of the bezel antenna 121.

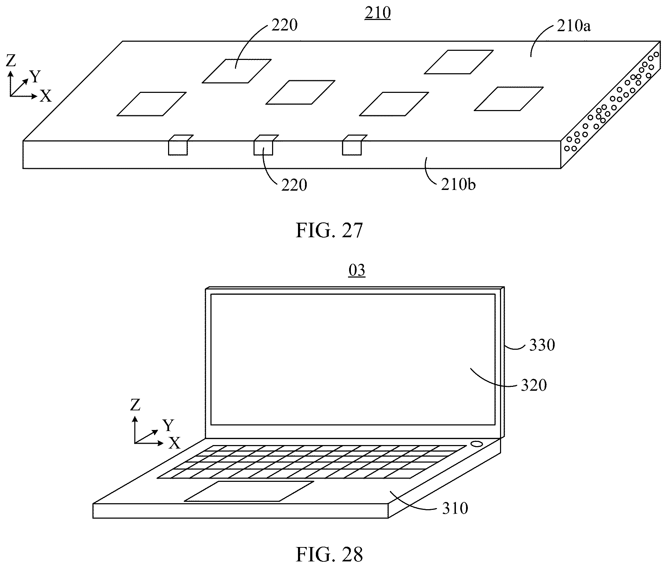

In addition, as shown in FIG. 27, it can be learned from the foregoing embodiment that a plurality of conductive parts 220 may be disposed on the first wall surface 210a and the second wall surface 210b of the mechanical part body 210 based on different function requirements. As shown in FIG. 14, each conductive part 220 forms a three-layer force-bearing structure including the carbon fiber filament 211, the base layer 222, and the conductive layer 221, and the conductive part 220 is further connected to the metal plating layer 240 (shown in FIG. 16). In this way, the plurality of conductive parts 220 can fasten the metal plating layer 240 at different positions. In this way, the conductive part 220 not only meets a requirement of a welding joint, but also can prevent the metal plating layer 240 from falling off from the surface of the mechanical part body 210.

The foregoing embodiment is an example in which the mechanical part 02 is used in the electronic device 01. An example in which the electronic device 01 is mainly a mobile phone is used. In addition, the mechanical part 02 may be further used in another electronic device 01. For example, the mechanical part 02 may be further used in an electronic device 01 like a notebook computer 03, a tablet computer, or an uncrewed aerial vehicle.

For example, as shown in FIG. 28, the notebook computer 03 may include a computer body 310, a screen 320, and a housing 330. The housing 330 may be rotatably connected to the computer body 310 via a part like a hinge or a rotating shaft, and the screen 320 may be connected to a side that is of the housing 330 and that faces the computer body 310 in a manner like pasting or clamping. The mechanical part 02 provided in this embodiment of this application may be used as the housing 330. In other words, a plurality of conductive parts 220 (shown in FIG. 27) in the foregoing embodiment may be disposed on a side that is of the housing 330 and that faces the screen 320, and the screen 320 may be electrically connected to the conductive part 220 on the housing 330 via the connecting piece 450 (shown in FIG. 24) in the foregoing embodiment. In this way, a grounding function of the screen 320 is implemented.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A mechanical part, comprising:
a mechanical part body, comprising an insulation part and a carbon fiber filament, wherein the carbon fiber filament is embedded in the insulation part, and a part of the carbon fiber filament is exposed outside the insulation part; and
a conductive part, wherein the conductive part is at least partially in contact with and electrically connected to the exposed carbon fiber filament.

2. The mechanical part according to claim 1, wherein a groove is disposed in a surface of the mechanical part body, and the part of the carbon fiber filament is exposed in the groove; and
the conductive part is at least partially disposed in the groove of the mechanical part body, and the conductive part is in contact with and electrically connected to the carbon fiber filament exposed in the groove.

3. The mechanical part according to claim 2, wherein a plurality of carbon fiber filaments are disposed, and the groove comprises a groove wall, a groove bottom, and groove space enclosed by the groove wall and the groove bottom; and
the exposed carbon fiber filament is disposed on at least one of the groove wall, the groove bottom, and the groove space.

4. The mechanical part according to claim 2, wherein a plurality of grooves are disposed in the surface of the mechanical part body, and the mechanical part body comprises a first wall surface and a second wall surface that are connected; and
one part of the groove is disposed on the first wall surface, and the other part of the groove is disposed on the second wall surface.

5. The mechanical part according to claim 3, wherein an outer surface of the exposed carbon fiber filament protrudes from the groove bottom, and the conductive part is in contact with and electrically connected to the outer surface of the carbon fiber filament protruding from the groove bottom.

6. The mechanical part according to claim 3, wherein the exposed carbon fiber filament has a first section plane, the first section plane is flush with the groove wall, and the conductive part is in contact with and electrically connected to the first section plane of the carbon fiber filament.

7. The mechanical part according to claim 3, wherein the exposed carbon fiber filament has a second section plane, the second section plane is flush with the groove bottom, and the conductive part is in contact with and electrically connected to the second section plane of the carbon fiber filament.

8. The mechanical part according to any one of claims 1 to 7, wherein the conductive part comprises a conductive layer and a base layer;
the base layer is disposed in the groove of the mechanical part body, and the base layer is in contact with and electrically connected to the exposed carbon fiber filament; and
the conductive layer is filled in the groove of the mechanical part body, and the conductive layer is in contact with and electrically connected to the base layer.

9. The mechanical part according to claim 8, wherein the exposed carbon fiber filament is provided with an uneven surface, and the groove comprises the groove wall and the groove bottom; and
the base layer is plated on the groove wall and the groove bottom, and is in contact with the uneven surface of the exposed carbon fiber filament.

10. The mechanical part according to claim 8, wherein alloy is formed through fusion at an interface between the conductive layer and the base layer.

11. The mechanical part according to claim 8, wherein a material of the conductive layer comprises tin, bismuth, gallium, or indium.

12. The mechanical part according to claim 8, wherein a material of the base layer comprises chromium, nickel, titanium, copper, iron, or aluminum.

13. The mechanical part according to any one of claims 1 to 12, wherein the mechanical part further comprises a connecting piece; and
the connecting piece is disposed on the conductive part, and is electrically connected to the conductive part.

14. The mechanical part according to claim 13, wherein the connecting piece comprises a pad, a conductive elastomer, or conductive silicone.

15. The mechanical part according to any one of claims 1 to 14, wherein the mechanical part further comprises a metal plating layer; and
the metal plating layer is plated on the outer surface of the mechanical part body, and the conductive part is electrically connected to the metal plating layer.

16. The mechanical part according to any one of claims 1 to 14, wherein the mechanical part further comprises graphene, and the graphene is embedded in the insulation part; and
the graphene is in contact with the carbon fiber filament.

17. The mechanical part according to any one of claims 1 to 16, wherein the mechanical part is a middle frame or a rear cover of the electronic device.

18. An electronic device, comprising:
a circuit board;
the mechanical part according to any one of claims 1 to 17; and
a connecting piece, electrically connected between the circuit board and the mechanical part.

19. The electronic device according to claim 18, wherein the connecting piece is disposed on the circuit board and is electrically connected to the circuit board; and
the connecting piece on the circuit board is electrically connected to the conductive part on the mechanical part.

20. The electronic device according to claim 18, wherein the connecting piece is disposed on the mechanical part, and is electrically connected to the conductive part; and
the circuit board is electrically connected to the connecting piece on the mechanical part.
